# EUROPEAN PATENT APPLICATION

(11) **EP 0 845 512 A1**
(43) Date of publication of application: **03.06.1998**
(21) Application number: 97309650.6
(22) Date of filing: 01.12.1997
(51) Int. Cl.: C09G 1/02, C23F 3/00

(54) **Polishing composition**

(30) Priority: 02.12.1996 JP 320639/96; 02.12.1996 JP 320640/96; 02.12.1996 JP 320644/96
(71) Applicant: FUJIMI INCORPORATED, Nishikasugai-gun Aichi-ken (JP)
(72) Inventor: Kodama, Hitoshi, c/o Fujimi Inc., Nishikasugai-gun, Aichi (JP); Ito, Masatoki, c/o Fujimi Inc., Nishikasugai-gun, Aichi (JP); Suzumura, Satoshi, c/o Fujimi Inc., Nishikasugai-gun, Aichi (JP)
(74) Representative: Paget, Hugh Charles Edward

(57) **Abstract**

A composition for polishing an aluminum, copper or tungsten film, which comprises water and a polishing agent selected from the group consisting of silicon dioxide, aluminum oxide, cerium oxide, silicon nitride and zirconium oxide, and which further contains an iron(III) compound dissolved in the composition, wherein the iron(III) compound is selected from the group consisting of iron(III) pyrophosphate, iron(III) citrate, iron(III) ammonium citrate, iron(III) ammonium oxalate, iron(III) ammonium sulfate, iron(III) perchlorate, iron(III) chloride, iron(III) sulfate and iron(III) phosphate.

## Description

The present invention relates to a polishing composition useful for polishing semiconductors, photomasks and various industrial products such as synthetic resins, or parts thereof. Particularly, it relates to a polishing composition suitable for use for planarization polishing of the surface of device wafers in the semiconductor industries. More particularly, the present invention relates to a polishing composition which provides a high polishing rate and is capable of forming an excellent polished surface in polishing a metal as wiring material, particularly an aluminum, copper or tungsten film, to which a chemical mechanical polishing technique has heretofore been applied, and which at the same time is applicable to high level integrated circuit fabrication.

The progress in so-called high technology products including computers has been remarkable in recent years, and with respect to parts such as ULSI to be used for such products, there has been a continuous progress for high density and high speed year by year. Accordingly, in the design rule for semiconductor devices, narrowing of wirings has progressed year by year, so that the depth of focus in a process for producing devices has become shallow and the requirement for flatness of the pattern-forming surface has become severe.

Further, to cope with an increase of the wiring resistance due to narrowing of wirings, stacking of devices is carried out to shorten the wiring length, but the step height of the formed pattern surface has been problematic as a hindrance against stacking.

Accordingly, to carry out such narrowing and stacking, it is necessary to carry out planarization of the desired surface to remove the step height in the process. For the planarization, spin on glass, resist etch back or other planarization methods have heretofore been employed.

However, by such conventional methods, it is difficult to attain global planarization (complete planarization) which is required for advanced devices, although partial planarization is possible. Accordingly, a chemical mechanical polishing (hereinafter referred to simply as "CMP") for planarization has now been studied, which is a combination of mechanical or physical polishing and chemical polishing.

On the other hand, a study is being made to apply the CMP technique to planarization of e.g. a wiring material such as an aluminum, copper or tungsten film, a polysilicon film, or an interlayer dielectric such as a silicon dioxide film, to separation of elements and to other applications.

Technical objectives in carrying out the planarization of a wiring material are to uniformly finish without excessive or insufficient stock removal by polishing the surface for planarization and to complete the polishing at a predetermined level of stock removal. Usually, it is common to provide a silicon dioxide film beneath the metal film to be polished, so that the silicon dioxide film serves as a stopper during the polishing. It should readily be understood that as a polishing agent to be used here, it is preferred to employ a polishing agent which is capable of efficiently polishing the metal film and which, on the other hand, is incapable of polishing the silicon dioxide film.

Usually, as an index for susceptibility to polishing of the metal film as a wiring material on the silicon dioxide film, selectivity for polishing (hereinafter referred to as "the selectivity") is used, which is the ratio of the rate at which the metal film is polished by the polishing agent to the rate at which the silicon dioxide film is polished by the same polishing agent. This selectivity is obtained by dividing the rate at which the metal film is polished by the polishing agent by the corresponding rate at which the silicon dioxide film is polished.

As is evident from the definition of this selectivity, even if the rate for polishing the silicon dioxide film by a polishing composition is constant, the selectivity becomes high as the rate for polishing the metal film becomes high. Likewise, even if the rate for polishing the metal film is constant, the selectivity becomes high as the rate for polishing the silicon dioxide film becomes low. Needless to say, a polishing agent is desired whereby the rate for polishing the silicon dioxide film is close to 0, and the rate for polishing the metal film is as high as possible.

Accordingly, even if the rate for polishing the metal film is high, the one whereby the rate for polishing the silicon dioxide film is high, is not required irrespective of how high the selectivity is. As the silicon dioxide film is expected to be a stopper to stop polishing, the one having high selectivity and a rate for polishing the silicon dioxide film being close to 0, is practically useful, even if the rate for polishing the metal film is rather low.

Further, if this selectivity is too high, a problem of dishing is likely to occur. The dishing means that when e.g. a wafer having a metal wiring on its surface, is polished, the surface of the metal wiring portion is excessively polished or etched by the polishing as compared with the entire wafer surface so that a recess is formed at the metal wiring portion. This dishing reduces the cross-section of the metal wiring portion and thus tends to increase the electrical resistance or cause breakage of the wiring. Here, the etching means that the metal film portion is chemically eroded by the polishing composition.

The present inventors have previously proposed a polishing composition comprising ammonium persulfate, silicon dioxide and water as a polishing composition which provides, in polishing a metal film as a wiring material, a high polishing rate of a metal film and presents a polished product having excellent polished surface and which at the same time has a relatively high selectivity (JP6-313164).

However, this composition tends to lead to dishing, since its etching action against an aluminum, copper and tungsten film is strong. Further, although the selectivity is relatively high as the rate for polishing the metal film is high, the rate for polishing a silicon dioxide film is likely high. Thus, it has had a room for improvement.

It is common to employ a polishing composition comprising aluminum oxide, hydrogen peroxide and water, for polishing an aluminum, copper or tungsten film. However, hydrogen peroxide has very poor stability as it undergoes natural decomposition in air. The polishing composition employing it, can not maintain its performance stably beyond a short period of time after preparation. Further, the container for such a composition is likely to undergo a change such as swelling in a few days to a few weeks. Further, it has had a problem that the rate for polishing an aluminum, copper or tungsten film is not adequate, and at the same time, the selectivity is small, and further, scratch marks are likely to form on the polished surface.

Usually, the metal film is formed in a thickness of from about 500 to 600 nm on a wafer. Whereas, the rate for polishing the metal film with a usual polishing composition is a few hundreds nm/min. Accordingly, with a polishing composition having a high rate for polishing the metal film, the metal film will be removed in a very short period of time after initiation of the polishing. In a case where a wafer having a metal film formed on a silicon dioxide film, is polished with a polishing composition, it is necessary to stop polishing precisely immediately after the removal of the metal film, otherwise polishing will extend to the silicon dioxide film as the stopper. In most cases, the rate for polishing the silicon dioxide film with the polishing composition is not 0. Accordingly, if polishing is continued after removal of the metal film, even the silicon dioxide film will also be polished, and in an extreme case, will be completely removed. As is evident from the foregoing, it is very important to detect the end point in the CMP treatment, and a polishing composition having a polishing rate suitable for the process i.e. within a range where the end point can accurately be detected, has been desired.

For example, in a case of polishing a wafer having a metal film formed on a silicon dioxide film, it is necessary to terminate the polishing of the metal film when the silicon dioxide film has been partially exposed. This timing is called "the end point", and detection of this end point is called "the end point detection". Various studies have been made on the method for detecting the end point. For example, a method of measuring the thickness of the remaining film during the polishing by irradiating a laser beam to the wafer from below the polishing table, and other methods have been proposed. However, none of such proposals has been practically useful. Accordingly, it is common to use a method wherein the time required for removing a certain predetermined thickness of metal film is calculated from the polishing rate which the polishing composition has, and polishing is carried out within the predetermined period of this calculated time, taking this as the end point.

The present invention has been made to solve the above problems, and it is an object of the present invention to provide a polishing composition which has a high rate for polishing an aluminum, copper or tungsten film, is less likely to bring about scratching and dishing and has a proper selectivity and other basic polishing characteristics, and which has excellent stability with little change with time during the storage, such having heretofore been desired for a polishing composition to be used for planarization by the CMP technique of an aluminum, copper or tungsten film as a wiring material applied on a semiconductor substrate surface.

The present invention provides a composition for polishing an aluminum, copper or tungsten film, which comprises water and a polishing agent selected from the group consisting of silicon dioxide, aluminum oxide, cerium oxide, silicon nitride and zirconium oxide, and which further contains an iron(III) compound dissolved in the composition, wherein the iron(III) compound is selected from the group consisting of iron(III) pyrophosphate, iron(III) citrate, iron(III) ammonium citrate, iron(III) ammonium oxalate, iron(III) ammonium sulfate, iron(III) perchlorate, iron(III) chloride, iron(III) sulfate and iron(III) phosphate.

The polishing composition of the present invention has a high rate for polishing an aluminum, copper or tungsten film, is less likely to bring about scratching and dishing and has a proper selectivity and other basic polishing properties, and it also has excellent stability with little change with time during the storage.

Now, the present invention will be described in detail with reference to the preferred embodiments.

### Polishing agent

A proper polishing agent to be used as the main polishing material among the components of the polishing composition of the present invention, is selected from the group consisting of silicon dioxide, aluminum oxide, cerium oxide, silicon nitride and zirconium oxide. Among them, a plurality of agents may be selected for use in combination.

The silicon dioxide includes colloidal silica, fumed silica and many other types which are different in nature or process for their production.

The aluminum oxide also includes α-alumina, δ-alumina, θ-alumina, κ-alumina and other morphologically different ones. Further, there is one called fumed alumina from the method of its preparation.

The cerium oxide includes trivalent and tetravalent ones from the viewpoint of the oxidation number, and it includes hexagonal system, cubic system and face-centered cubic system, from the viewpoint of the crystal system.

The silicon nitride includes α-silicon nitride, β-silicon nitride, amorphous silicon nitride and other morphologically different ones.

The zirconium oxide includes monoclinic system, tetragonal system and amorphous one, from the viewpoint of the crystal system. Further, there is one called fumed zirconia from the method for its preparation.

For the composition of the present invention, these polishing agents may be used optionally and in combination as the case requires. The type of the combination and the ratio are not particularly limited.

The above polishing agent is intended to polish the surface to be polished, by a mechanical action as abrasive grains. The particle size of silicon dioxide among these, is usually from 0.005 to 0.5 µm, preferably from 0.01 to 0.2 µm, as a mean particle size measured by a BET method. Further, the particle size of each of the aluminum oxide, the silicon nitride and the zirconium oxide is usually from 0.01 to 10 µm, preferably from 0.05 to 3 µm, as a mean particle size measured by a BET method. Further, the particle size of the cerium oxide is usually from 0.01 to 10 µm, preferably from 0.05 to 3 µm, as a mean particle size observed by a scanning type electron microscope.

If the sizes of these polishing agents, exceed the above ranges, there will be problems such that the surface roughness of the polished surface will be large, and scratching is likely to occur. On the other hand, if the sizes are smaller than the above ranges, the polishing rate will be extremely small, such being not practical.

The content of the polishing agent in the polishing composition is usually from 0.1 to 50 wt%, preferably from 1 to 25 wt%, based on the total amount of the composition. If the content of the polishing agent is too small, the polishing rate tends to be low. On the other hand, if it is too much, uniform dispersion will not be maintained, and the viscosity of the composition tends to be high, whereby handling may sometimes be difficult.

### Water

The water to be used in the present invention is not particularly limited, provided that it does not impair the effects of the present invention, and it may, for example, be industrial water, city water, deionized water, distilled water or ultrapure water. The content of the water in the polishing composition of the present invention is usually from 10 to 99.89 wt%, preferably from 55 to 98.95 wt%.

### Iron(III) compound

The iron(III) compound serves to accelerate the polishing operation by a chemical action as a polishing accelerator. The iron(III) compound to be used, is required to be dissolved in the composition, and it is selected from the group consisting of iron(III) pyrophosphate, iron(III) citrate, iron(III) ammonium citrate, iron(III) ammonium oxalate, iron(III) ammonium sulfate, iron(III) perchlorate, iron(III) chloride, iron(III) sulfate and iron(III) phosphate. Specifically, for the treatment of an aluminum film, it is preferably selected from the group consisting of iron(III) ammonium sulfate, iron(III) citrate, iron(III) ammonium citrate and iron(III) ammonium oxalate. For the treatment of a copper or tungsten film, it is preferably selected from the group consisting of iron(III) citrate, iron(III) ammonium citrate, iron(III) ammonium oxalate, iron(III) ammonium sulfate, iron(III) perchlorate, iron(III) chloride and iron(III) sulfate. More specifically, for the treatment of a tungsten film, it is preferably selected from the group consisting of iron(III) ammonium sulfate and iron(III) sulfate, and for the treatment of a copper film, it is preferably iron(III) citrate. These iron(III) compounds may be used in combination in an optional ratio.

Further, as an iron compound to be incorporated in the composition of the present invention, an iron(II) compound may also be used. In such a case, the iron(II) compound will be oxidized and converted to be trivalent in the composition. This oxidation reaction may be carried out by an addition of an oxidizing agent or simply by oxygen in air.

For the purpose of the present invention, iron(III) nitrate is not suitable, since it is likely to bring about scratching or dishing.

The content of the iron(III) compound in the polishing composition of the present invention varies depending upon the effects of the particular compound to be used. However, it is preferably from 0.01 to 40 wt%, more preferably from 0.05 to 20 wt%, based on the total amount of the polishing composition. There is a tendency that as the amount of the iron(III) compound increases, the effects of the present invention will be stronger. However, if the amount is excessive, the degree of improvement tends to be small, and thus an economical demerit may be brought about.

### Polishing composition

The polishing composition of the present invention is prepared usually by mixing and dispersing the above-mentioned polishing agent selected from the group consisting of silicon dioxide, aluminum oxide, cerium oxide, silicon nitride and zirconium oxide in a desired content in water, and further dissolving the iron(III) compound therein. The method for dispersing or dissolving these components in water is optional. For example, they may be dispersed by stirring with an agitator or by ultrasonic dispersion. The order for mixing these components is also optional. Namely, either the dispersion of the polishing agent or the dissolution of the iron(III) compound may be carried out prior to the other, or they may be carried out simultaneously.

Further, for the preparation of the polishing composition, various known additives may be incorporated for the purpose of stabilizing or maintaining the quality of the product or as required depending upon the type of the object to be processed, the processing conditions and other polishing requirements.

Preferred examples of such further additives include (a) celluloses, such as cellulose, carboxymethylcellulose and hydroxyethylcellulose, (b) water-soluble alcohols, such as ethanol, propanol and ethylene glycol, (c) surfactants, such as sodium alkylbenzene sulfonate and a condensate of formalin with naphthalene sulfonic acid, (d) organic polyanion substances, such as a lignin sulfonate and a polyacrylate, (e) inorganic salts, such as ammonium sulfate, magnesium chloride, potassium acetate and aluminum nitrate, (f) water-soluble polymers (emulsifiers), such as polyvinyl alcohol, and (g) titanium oxide, such as titania, fumed titania, and others.

The polishing composition of the present invention will usually have a pH of at most 7 by the addition of its main component. The pH of the polishing composition may change by an addition of various auxiliary additives. To obtain the effects of the present invention, the pH is preferably at most 7. Accordingly, if the pH of the polishing composition exceeds 7, it is preferred to adjust the pH by an addition of an acid or the like.

The aluminum, copper or tungsten film to be polished by the polishing composition of the present invention, may be an aluminum, copper or tungsten film for wiring applied on a semiconductor substrate surface. The aluminum, copper or tungsten which constitutes such an aluminum, copper or tungsten film, may be any such material which is used for wiring. For example, gold, silver, platinum, copper, zinc, aluminum, tungsten, etc. other than the respective main metal, may be incorporated.

The polishing composition of the present invention may be prepared in the form of a stock solution having a relatively high concentration, which may be stored or transported and which is diluted for use at the time of actual polishing operation. The above-mentioned preferred ranges of concentration are those for actual polishing operation. Accordingly, when the composition is stored or transported in the form of a stock solution, such a stock solution is prepared to have a higher concentration.

The mechanism has not yet been clearly understood as to the reason why, when the polishing composition of the present invention is used for planarization of an aluminum, copper or tungsten film, formation of surface defects such as scratching or dishing is little, the rate for polishing the aluminum, copper or tungsten film is high, and the stability as a polishing composition is excellent. However, the following is conceivable.

As to the reason why formation of scratch marks is little, it is considered that a proper agglomeration/dispersion state among polishing particles due to iron ions of the iron(III) compound prevents formation of unduly large agglomerates. As to the reason why dishing is little, it is considered that the iron(III) ions provide a proper etching action to the aluminum, copper or tungsten film. Further, with respect to the reason why the rate for polishing the aluminum, copper or tungsten film is high, it is considered that the aluminum, copper or tungsten film undergoes a chemical change due to the iron(III) ions and becomes brittle, whereby it tends to be susceptible to polishing effects by the mechanical action of the polishing agent.

The polishing composition of the present invention prepared as described above is excellent in the stability and is less likely to bring about scratching or other surface defects, or formation of dishing. Accordingly, it is useful for polishing semiconductor devices, photomasks, synthetic resins and other materials. However, since it has a proper selectivity with a high rate for polishing an aluminum, copper or tungsten film, it is particularly useful in the semiconductor industry for planarization of an aluminum, copper or tungsten film on a device wafer.

Now, the polishing composition of the present invention will be described in further detail with reference to Examples. However, it should be understood that the present invention is by no means restricted to the specific constructions of the following Examples.

### EXAMPLES 1 to 29 and COMPARATIVE EXAMPLES 1 to 18

### Preparation of polishing compositions

Firstly, as polishing agents, colloidal silica (mean primary particle size: 0.035 µm), aluminum oxide (mean primary particle size: 0.2 µm), cerium oxide (mean primary particle size: 0.2 µm), silicon nitride (mean primary particle size: 0.2 µm) and zirconium oxide (mean primary particle size: 0.2 µm) were, respectively, dispersed in water by an agitator to obtain slurries each having a polishing agent concentration of 10 wt%. Then, to these slurries, various additives as identified in Table 1 were added each in an amount of 0.1 mol/ℓ, to obtain samples of Examples 1 to 29 and Comparative Examples 1 to 18.

### Polishing tests

Then, polishing tests were carried out by means of these samples.

As the object to be polished, a substrate of 6 inch silicon wafer (outer diameter: about 150 mm) having an aluminum, copper or tungsten film formed by a sputtering method, was used. The aluminum, copper or tungsten film surface and a silicon dioxide film surface were polished.

Polishing was carried out by means of a single side polishing machine (table diameter: 570 mm). A non-woven fabric type polishing pad (Surfin III-1, manufactured by Fujimi Incorporated) was bonded to the table of the polishing machine. Firstly, a wafer provided with an aluminum, copper or tungsten film was mounted and polished for 2 minutes, and then the wafer was changed to a wafer provided with a silicon dioxide film, which was polished for 2 minutes in the same manner.

The polishing conditions were such that the polishing pressure was 490 g/cm², the rotational speed of the polishing table was 30 rpm, the feeding rate of the polishing composition was 150 cc/min, and the rotational speed of the wafer was 30 rpm.

After the polishing, the wafer was sequentially washed and dried, whereupon the reduction in the film thickness of the wafer by polishing was measured with respect to 49 samples, and the polishing rate was obtained for each test.

Further, the selectivity was obtained by dividing the rate at which the aluminum, copper or tungsten film was polished by the rate at which the silicon dioxide film was polished.

With respect to scratching, after polishing, each wafer was washed and dried, whereupon the presence or absence of scratch marks was visually observed under a spotlight in a dark room. The evaluation standards were as follows.
- ⓞ: No scratch marks were visually observed.
- ○: No substantial scratch marks were visually observed.
- Δ: Some scratch marks were visually observed, but they were of a no problematic level.
- ×: Substantial scratch marks were visually observed, and they were of a problematic level.

Further, for the evaluation of dishing, the etching rate was measured as a substitute characteristic. The etching rate was determined in such a manner that wafers provided respectively with an aluminum film, a copper film and a tungsten film, were immersed in the respective polishing compositions for a predetermined period of time, and the changes in the film thicknesses were measured before and after the immersion, whereupon the respective etching rates were obtained by dividing the changes of the film thicknesses by the respective periods of immersion times. Here, the larger the etching rate, the more likely the formation of dishing. The etching rate was measured in such a manner, and evaluated under the following standards.
- ⓞ: Etching rate of less than 0.5 nm/min.
- ○: Etching rate of from 0.5 to 1 nm/min.
- Δ: Etching rate of from 1 to 10 nm/min.
- ×: Etching rate of more than 10 nm/min.

The obtained results are as shown in Table 1.

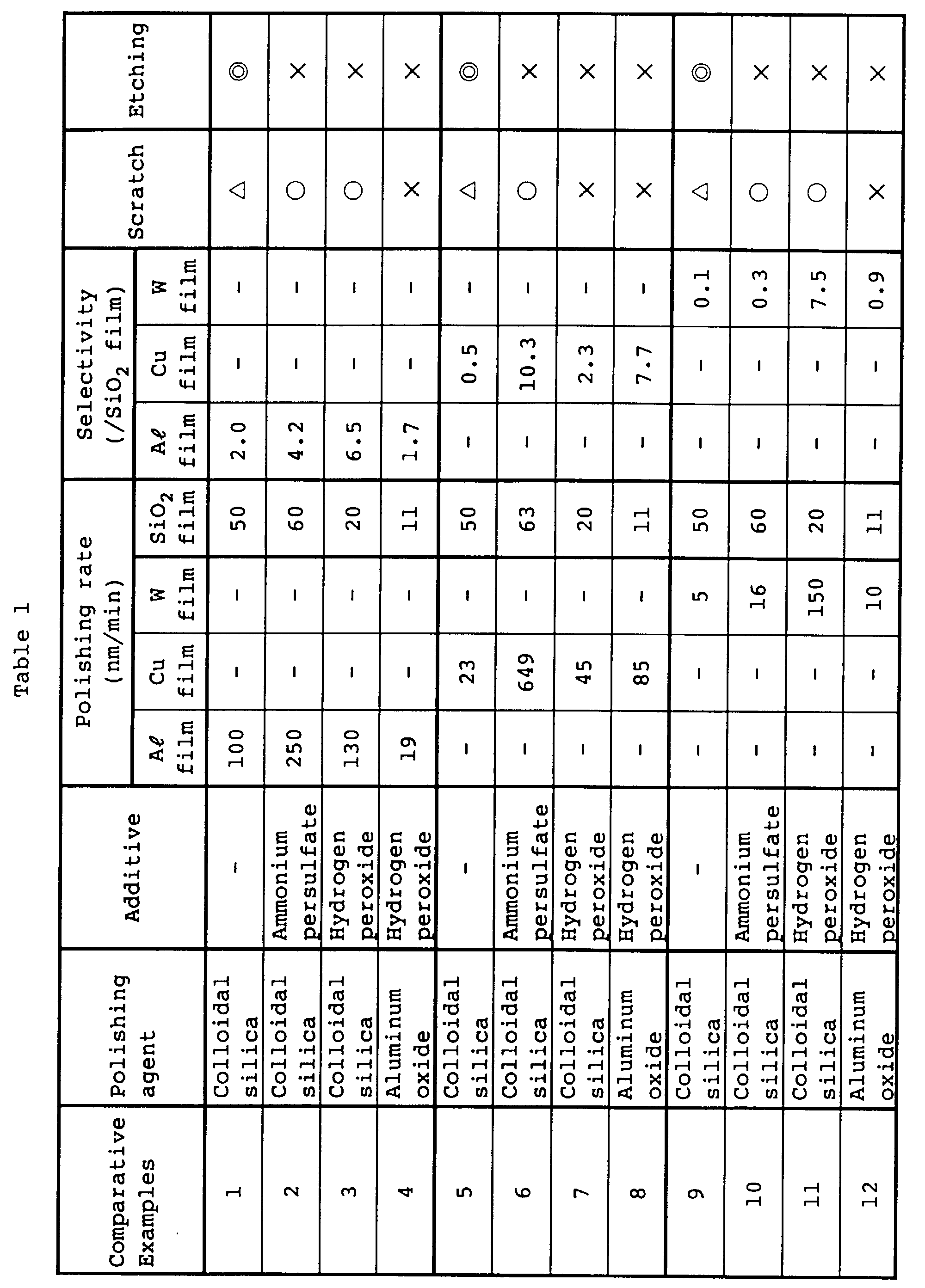

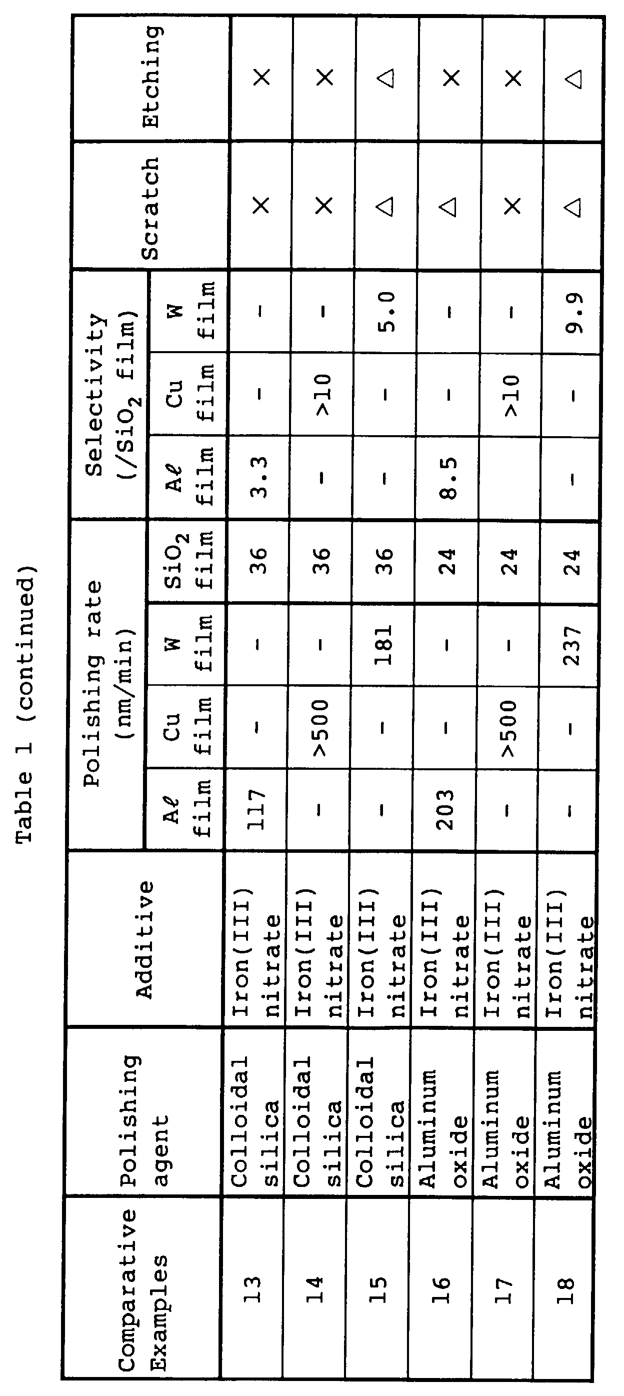

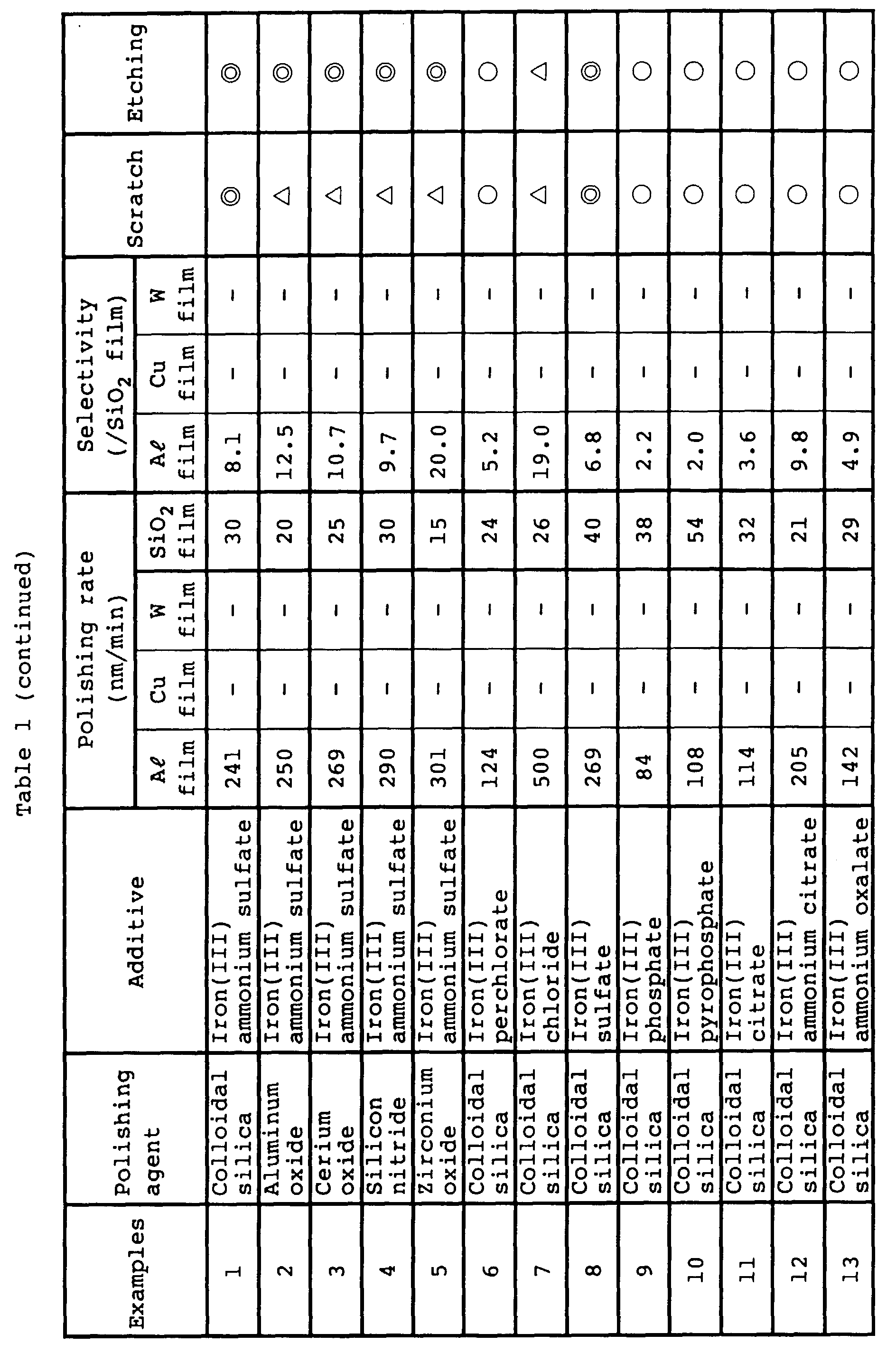

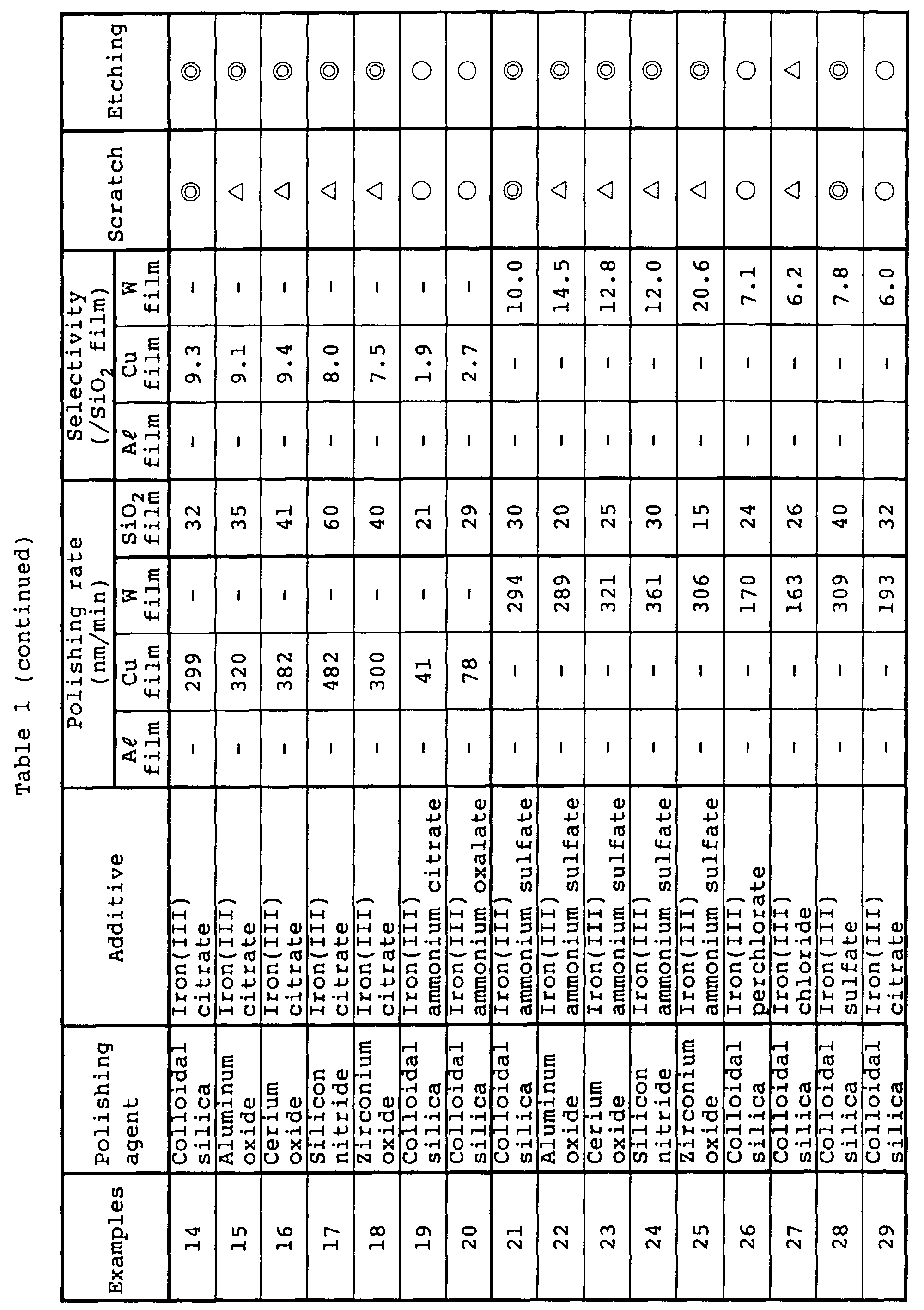

From the results shown in Table 1, it is evident that the polishing composition of the present invention has a high rate for polishing an aluminum, copper or tungsten film, and exhibits excellent results with respect to both scratching and dishing.

Although not indicated in Table 1, the polished surfaces of the samples used for these tests, were visually evaluated, whereby in both Examples and Comparative Examples, no surface defects other than scratch marks were observed. Further, the polishing compositions of the present invention were left to stand still for 1 month after their preparation, whereby no changes, such as swelling of the containers or color changes of the compositions, due to e.g. decomposition of some components in the compositions, were observed.

As described in the foregoing, the polishing composition of the present invention has a high rate for polishing an aluminum, copper or tungsten film, is less likely to bring about dishing, scratching or any other surface defects on the polished surface, and has an excellent stability during the storage.

## Claims

1. A composition for polishing an aluminum, copper or tungsten film, which comprises water and a polishing agent selected from the group consisting of silicon dioxide, aluminum oxide, cerium oxide, silicon nitride and zirconium oxide, and which further contains an iron(III) compound dissolved in the composition, wherein the iron(III) compound is selected from the group consisting of iron(III) pyrophosphate, iron(III) citrate, iron(III) ammonium citrate, iron(III) ammonium oxalate, iron(III) ammonium sulfate, iron(III) perchlorate, iron(III) chloride, iron(III) sulfate and iron(III) phosphate.

2. The polishing composition for polishing an aluminum film according to Claim 1, wherein the iron(III) compound is selected from the group consisting of iron(III) ammonium sulfate, iron(III) citrate, iron(III) ammonium citrate and iron(III) ammonium oxalate.

3. The polishing composition for polishing a copper or tungsten film according to Claim 1, wherein the iron(III) compound is selected from the group consisting of iron(III) citrate, iron(III) ammonium citrate, iron(III) ammonium oxalate, iron(III) ammonium sulfate, iron(III) perchlorate, iron(III) chloride and iron(III) sulfate.

4. The polishing composition for polishing a tungsten film according to Claim 1, wherein the iron(III) compound is selected from the group consisting of iron(III) ammonium sulfate and iron(III) sulfate.

5. The polishing composition for polishing a copper film according to Claim 1, wherein the iron(III) compound is iron(III) citrate.

6. The polishing composition according to any one of Claims 1 to 5, wherein, based on the total amount of the composition, the polishing agent is in an amount of from 0.1 to 50 wt%, the water is in an amount of from 10 to 99.89 wt%, and the iron(III) compound is in an amount of from 0.01 to 40 wt%.

7. The polishing composition according to any one of Claims 1 to 6, wherein the silicon dioxide has a mean particle size of from 0.005 to 0.5 µm as measured by a BET method, each of the aluminum oxide, the silicon nitride and the zirconium oxide has a mean particle size of from 0.01 to 10 µm as measured by a BET method, and the cerium oxide has a mean particle size of from 0.01 to 10 µm as measured by a scanning electron microscope.

8. The use of the composition as defined in any one of Claims 1 to 7 as an agent for polishing an aluminum, copper or tungsten film.

9. A method for polishing an aluminum, copper or tungsten film, wherein the composition as defined in any one of Claims 1 to 7 is used as an agent for polishing the aluminum, copper or tungsten film.
